# EUROPÄISCHE PATENTSCHRIFT

(11) **EP 1 032 846 B1**
(45) Veröffentlichungstag und Bekanntmachung des Hinweises auf die Patenterteilung: **19.09.2001**
(21) Anmeldenummer: 98965081.7
(22) Anmeldetag: 18.11.1998
(51) Int. Cl.: G01R 31/28

(54) **DIAGNOSEEINRICHTUNG ZUR ERKENNUNG VON KURZSCHLÜSSEN ODER LEITUNGSUNTERBRECHUNGEN EINES INDUKTIVEN SENSORS**
DIAGNOSTIC DEVICE FOR RECOGNIZING SHORT CIRCUITS OR LINE INTERRUPTIONS OF AN INDUCTIVE SENSOR
DISPOSITIF DE DIAGNOSTIC DESTINE A DETECTER DES COURTS-CIRCUITS ERRONES OU DES INTERRUPTIONS DE LIGNES DE CAPTEURS INDUCTIFS

(30) Priorität: 20.11.1997 DE 19751530
(43) Veröffentlichungstag der Anmeldung: 06.09.2000
(73) Patentinhaber: SIEMENS AKTIENGESELLSCHAFT, 80333 München (DE); Punzmann, Horst, Canberra, ACT 2602 (AU)
(72) Erfinder: PUNZMANN, Horst, Canberra, ACT 2602 (AU); DIETL, Franz, F-31270 Cugnaux (FR); FISCH, Alfons, D-93167 Falkeinstein-Völling (DE); VOGEL, Frank, D-93051 Regensburg (DE)
(86) Internationale Anmeldenummer: DE9803414
(87) Internationale Veröffentlichungsnummer: WO9927377

(56) Entgegenhaltungen:
- DE-A- 2 841 289
- DE-A- 4 322 490
- DE-A- 19 526 435

## Beschreibung

Die Erfindung betrifft eine Diagnoseeinrichtung zur Erkennung von Fehlschlüssen oder Leitungsunterbrechungen eines induktiven Sensors, insbesondere von Kurzschlüssen nach Batteriespannung bzw. Masse oder Leitungsunterbrechungen eines in einem Kraftfahrzeug verwendeten induktiven Sensors, beispielsweise eines Kurbel- oder Nockenwellensensors einer Brennkraftmaschine oder eines Radsensors eines Antiblockiersystems (ABS) oder Antriebsschlupfregelsystems (ASR), nach dem Oberbegriff des Anspruchs 1.

Ein induktiver Sensor besteht in der Regel aus einer um einen magnetisierten Kern gewickelten Spule, an welchem ein Gebelelement in Form eines mit der Kurbel- oder Nockenwelle oder einem Rad synchron laufenden Zahnrades aus ferromagnetischem Material vorbeibewegt wird, dessen Flanken beim Vorbeibewegen am Sensor in dessen Spule eine charakteristische Spannung induzieren. Über eine dem Sensor nachgeschaltete Auswerteelektronik, die einen Komparator enthält, wird diese Spannung erfaßt und zu einem digitalen Ausgangssignal geformt, das in nachfolgenden Steuer- oder Regeleinrichtungen weiterverarbeitet wird.

Prinzipiell lassen sich induktive Sensoren überall dort einsetzen, wo Position oder Drehzahl bzw. Geschwindigkeit eines bewegbaren Geberelements erfaßt werden soll.

Bei Leitungsunterbrechung oder Kurzschluß liefert ein derartiger Sensor bei symmetrischer Eingangsbeschaltung immer noch ein Ausgangssignal, dessen Verlauf keine sichere Erkennung des Fehlers zuläßt. Damit können aber hohe Anforderungen, die im Rahmen vorgeschriebener On-Boaed-Diagnose gestellt werden, nicht sicher erfüllt werden. Fehldiagnosen wären die Folge.

Im Zuge der Entwicklung elektronischer Komponenten für die Kraftfahrzeug-Elektronik hat sich die Erfordernis gezeigt, Fehlschlüsse oder Leitungsunterbrechungen, die an beliebigen Stellen im Sensor oder in den Sensorleitungen auftreten können, erfaßbar, auswertbar und anzeigbar zu machen.

Aus der DE-PS 28 41 289 ist ein Verfahren und eine Vorrichtung zum Prüfen von induktiven Sensoren bekannt. Dabei werden ein der Amplitude der vom Impulsgeber erzeugten Spannung proportionales erstes Signal und gleichzeitig ein der Frequenz der Impulse proportionales zweites Signal gebildet. Aus dem Verhältnis vom ersten zu zweitem Signal wird ein drittes Signal gebildet, das mit einer vorgegebenen, für die Impulsgeberbauart typischen Größe verglichen wird, wobei die Differenz zwischen drittem Signal und typischer Größe als Gütekriterium verwendet wird. Die Bildung der drei Signale erfolgt gleichzeitig mittels einer Spule als Tiefpaß, die mit einem Nebenwiderstand zwischen die Anschlüsse des induktiven Gebers geschaltet ist, wobei am Verbindungspunkt von Spule und Widerstand eine Auswerteeinheit angeschlossen ist. Dieses Verfahren und die zugehörige Vorrichtung dienen dem Zweck, eine Überprüfung des induktiven Impulsgebers im interessierenden Frequenz- oder Drehzahlbereich, insbesondere bei niedrigen Drehzahlen vornehmen zu können. Ferner soll bei Radsensoren von Antiblockiersystemen überprüft werden, ob genügend hohe Signale abgegeben werden, so daß auch die Position des Radsensors in Bezug zum Geberelement geprüft werden kann. Es werden Fehlerquellen, die im wesentlichen direkt im induktiven Sensor auftreten, detektiert und ausgewertet.

Aus der DE 195 26 435 A1 ist eine Schaltungsanordnung zur Fehler- oder Leckstromerkennung auf der Versorgungsleitung einer elektronischen Schaltung bei abgeschalteter Versorgungsspannung bekannt. Mit der Versorgungsleitung ist sowohl eine von einer Hilfsspannung gespeiste Stromquelle als auch ein nach Masse führender Spannungsteiler verbunden, über dessen Abgriff das sich bei abgeschalteter Versorgungsspannung auf der Versorgungsleitung einstellende Potential mittels eines Potentialmonitors ermittelt und ausgewertet wird. Mit dieser Schaltung sind bei eingeschalteter Versorgungsspannung weder Schlüsse zur Batteriespannung oder zum Massepotential noch Leitungsunterbrechungen detektierbar.

Der vorliegenden Erfindung liegt die Aufgabe zugrunde, eine Diagnoseeinrichtung zu schaffen, mit welcher sowohl Kurzschlüsse nach Masse oder Batteriespannung nicht nur bei Stillstand des Sensors, sondern auch im Betriebsfall, und zusätzlich auch Leitungsbrüche im Sensor oder seinen Zuleitungen im gesamten Frequenzbereich des Sensors sicher erkannt, ausgewertet und angezeigt werden können.

Diese Aufgabe wird erfindungsgemäß durch die Merkmale des Anspruchs 1 gelöst.

Die erfindungsgemäße Diagnoseeinrichtung hat den wesentlichen Vorteil, daß einfache Hard- oder Softwarekomponenten genügen, um die genannten Fehler sicher zu detektieren und anzuzeigen.

Weitere vorteilhafte Ausgestaltungen der Erfindung sind den Unteransprüchen zu entnehmen.

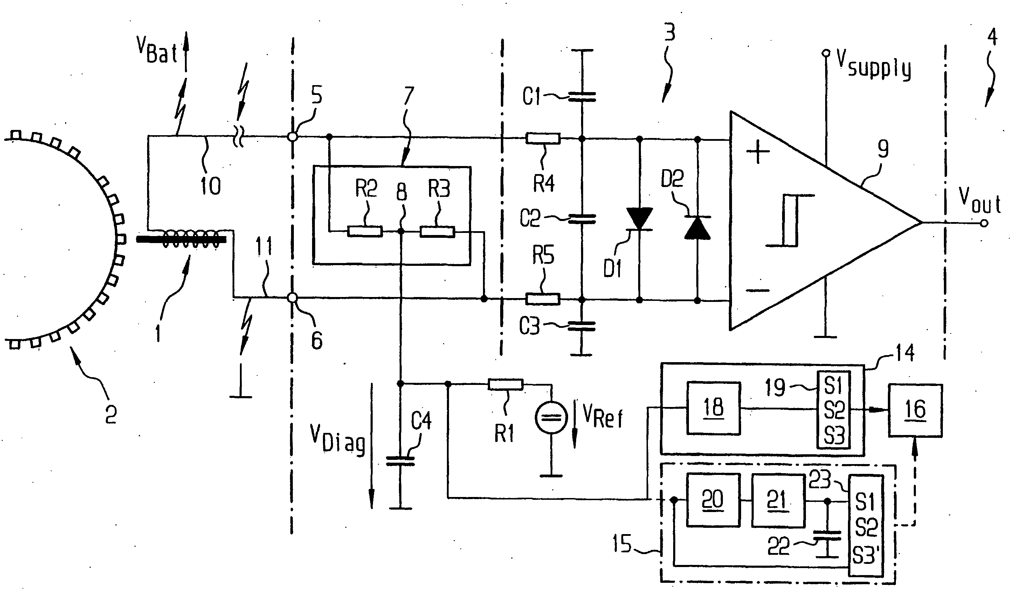

Ein Ausführungsbeispiel der Erfindung ist in der Zeichnung dargestellt.

Die einzige Figur zeigt einen induktiven Kurbelwellen-Sensor 1 einer Kraftfahrzeug-Brennkraftmaschine, bestehend aus einer um einen magnetisierten Kern gewickelten Spule, an dem ein Geberelement 2 vorbeibewegbar ist. Das Geberelement 2 ist ein mit der Kurbelwelle der Brennkraftmaschine verbundenes Zahnrad. Mit Bezugszeichen 10 und 11 sind die Zuleitungen zwischen Sensor und Auswerteeinheit bezeichnet. Bezugszeichen 5 und 6 bezeichnen die Anschlüsse des induktiven Sensors 1. Diese Anschlüsse 5 und 6 führen über zwei Widerstände R4 und R5 an eine nachgeschaltete Auswerteelektronik 3, die von einer Versorgungsspannungsquelle Vsupply betrieben wird, die über einen Festspannungsregler aus der Batteriespannungsquelle Vbat des Kraftfahrzeugs abgeleitet wird.

Die Auswerteelektronik 3 besteht im wesentlichen aus einem Komparator 9, dessen digitales Ausgangssignal Vout das Sensorsignal ist, welches einem Motorsteuergerät 4 zugeführt wird. Der Komparator 9 kann eine nicht dargestellte Hysteresebeschaltung aufweisen. Zwischen nichtinvertierendem (+) und invertierendem (-) Eingang des Komparators 9 sind zwei antiparallele Dioden D1 und D2 zur Signalbegrenzung geschaltet. Zwischen die beiden Eingänge des Komparators 9 ist ein Kondensator C2 geschaltet; zwischen nichtinvertierendem Eingang (+) und Massebezugspotential liegt ein Kondensator C1 und zwischen invertierendem Eingang (-) und Massebezugspotential liegt ein Kondensator C3. Die Kondensatoren C1, C2, C3 haben im Zusammenwirken mit den Widerständen R4 und R5 eine Tiefpaßcharakteristik, um hochfrequente Anteile des induktiven Sensorsignals bzw. Störungen auszublenden. Am Ausgang des Komparators 9 erscheint das für die Weiterverarbeitung digitalisierte Sensorsignal.

Zwischen die Anschlüsse 5 und 6 des induktiven Sensors 1 ist ein Spannungsteiler 7, in diesem Ausführungsbeispiel bestehend aus zwei Widerständen R2 und R3, geschaltet, dessen Abgriff 8 über einen Widerstand R1 mit einer Referenzspannung Vref beaufschlagt ist. An diesem Anschluß 8 ist eine Diagnosespannung Vdiag abgreifbar, die, wie nachstehend beschrieben, zur Diagnose von charakteristischen Fehlschlüssen oder Leitungsunterbrechungen auswertbar ist. Zwischen Abgriff 8 und Massebezugspotential ist zur Ausblendung hochfrequenter Störungen ein Kondensator C4 geschaltet.

Der aus Widerständen bestehende Spannungsteiler 7 ist symmetrisch, d.h., R2 = R3. Im Stillstand der Brennkraftmaschine, wenn keine Fehlschlüsse vorhanden sind, entspricht die Diagnosespannung Vdiag der Referenzspannung Vref, der im Betriebsfall bei rotierender Kurbelwelle das Sensorsignal, eine Wechselspannung, überlagert ist.

Die am Abgriff 8 anstehende Diagnosespannung Vdiag wird einer Auswerteeinrichtung 14 zugeführt, die in einem nicht dargestellten Mikroprozessor enthalten ist, und welche im wesentlichen die Funktionen eines Analog-Digitalwandlers 18 und einer diesem nachgeschalteten Komparatoreinheit 19 ausführt.

Im Betriebsfall bei rotierender Kurbelwelle ist der Referenzspannung Vref das Sensorsignal, eine Wechselspannung, überlagert. Beide zusammen bilden die Diagnosespannung Vdiag.

Das bei laufender Brennkraftmaschine entstehende Sensorsignal hat einen annähernd sinusförmigen Verlauf mit veränderlicher Frequenz. Die Periodendauer entspricht der aktuellen Zahnzeit eines Zahnes des Geberelementes, d.h., der Drehzahl der Brennkraftmaschine. Dieses Sensorsignal wird in der Auswerteeinrichtung 14 in laufend aufeinanderfolgenden Meßperioden Tm (von beispielsweise einigen 10 ms Dauer) in zeitlichen Abständen abgetastet, die von der Verarbeitungskapazität des verwendeten Mikroprozessors abhängig sind und je nach Frequenz des Sensorsignals Unter- oder Überabtastung bedeuten, wobei bei konstanter Periodendauer des Sensorsignals die Abtastfrequenz veränderbar gewählt wird, um konstante Abtastwerte zu vermeiden.

Der jeweils größte und kleinste Abtastwert in jeder Meßperiode Tm werden als maximaler Amplitudenwert Vmax und minimaler Amplitudenwert Vmin des Sensorsignals dieser Meßperiode Tm betrachtet und aus diesen beiden Werten wird die Differenz Vss = Vmax - Vmin berechnet. Je länger die Meßperiode Tm beziehungsweise je höher die Anzahl der Abtastwerte pro Meßperiode ist, desto genauer erfolgt die Bestimmung von Vss.

Tritt im Betriebsfall ein Fehler auf (Kurzschluß nach Batteriespannung oder Masse bzw. Leitungsbruch), so wird das Sensorsignal, d.h., die Differenz Vss größer als im fehlerfreien Normalfall. Durch Vergleich der Differenz Vss mit einem dritten Schwellwert S3 in der Komparatoreinheit 19 kann dieser Fall sicher diagnostiziert werden: ein Fehler tritt auf, wenn Vss > S3.

Im Stillstand der Brennkraftmaschine fließt bei einem Kurzschluß zwischen einer der Verbindungsleitungen 10 oder 11 und der Batteriespannung Vbat zwischen dieser und der Referenzspannungsquelle Vref über die Widerstände R1 und die Parallelschaltung von R2 und R3 ein Ausgleichsstrom, der an allen Widerständen einen Spannungsabfall erzeugt. Die Diagnosespannung Vdiag am Verbindungspunkt 8 entspricht dann der Summe von Referenzspannung Vref und der am Widerstand R1 abfallenden Spannung V(R1): Vdiag = Vref + V(R1).

Bei einem angenommenen Kurzschluß (ebenfalls im Stillstand der Brennkraftmaschine) zwischen einer der Verbindungsleitungen 10 oder 11 und Massebezugspotential fließt ein Strom von der Referenzspannungsquelle Vref über Widerstand R1 und die Parallelschaltung von R2 und R3 zum Massebezugspotential. Die Diagnosespannung Vdiag am Verbindungspunkt 8 ist dann um den Spannungsabfall V(R1) am Widerstand R1 kleiner als die Referenzspannung Vref: Vdiag = Vref - V(R1).

Durch Vergleich der abgetasteten Diagnosespannung Vdiag mit dem ersten und zweiten Schwellwert S1 und S2 in der Komparatoreinheit 19, wobei beispielsweise S1 = Vref + V(R1)/2 und S2 = Vref - V(R1)/2 (beide Schwellwerte müssen jedoch nicht symmetrisch zur Referenzspannung liegen), können diese Fehler sicher diagnostiziert und angezeigt werden. Da in diesem Fall die Abtastwerte konstant sind, ist die Differenz Vss = 0V und Vss < S3.

Ein Leitungsbruch kann im Stillstand der Brennkraftmaschine nicht detektiert werden.

Tritt ein Fehler im Betriebsfall auf, aber nicht im Stillstand der Brennkraftmaschine, so kann daraus auf Leitungsbruch geschlossen werden.

Die aufgetretenen Fehler können über eine Anzeigeeinrichtung 16 angezeigt werden.

Die beschriebene Auswertung erfordert einen geringen Aufwand an Hardware, da ein ohnehin vorhandener Mikroprozessor mit benutzt werden kann; aber dafür ist ein etwas größerer Aufwand an Software erforderlich.

Das gleiche Auswertungsergebnis im Betriebsfall kann mit etwas mehr Hardwareaufwand und ohne Softwareaufwand erreicht werden, wenn anstelle der Auswerteeinrichtung 14 eine strichliert gezeichnete Auswerteeinrichtung 15 verwendet wird, die einen Hochpaß 20 aufweist, dem ein Gleichrichter 21, ein Kondensator 22 (oder Tiefpaß oder Integrator) und eine Komparatoreinheit 23 folgen.

Im Hochpaß 20 wird der Gleichspannungsanteil der Diagnosespannung Vdiag weggefiltert. Das verbleibende Sensorsignal wird im Gleichrichter 21 gleichgerichtet und im Kondensator 22 zu einem Gleichspannungssignal Vss' geformt, welches in der nachfolgenden Komparatoreinheit 23 mit einem Schwellwert S3' verglichen wird. Ein Kurzschluß nach Batteriespannung bzw. nach Masse oder Leitungsbruch liegt vor, wenn Vss' > S3'. Im Stillstand der Brennkraftmaschine muß in diesem Fall das ursprüngliche Diagnosesignal Vdiag in der Komparatoreinheit 23 mit beiden Schwellwerten S1 und S2 verglichen werden.

Insgesamt ergibt sich folgende Auswertung:
im Betriebsfall der Brennkraftmaschine:
   Kurzschluß nach Batteriespannung bzw. nach Masse oder Leitungsbruch liegt vor, wenn Vss > S3 oder Vss' > S3';
im Stillstand der Brennkraftmaschine:
   Kurzschluß nach Batteriespannung liegt vor, wenn Vdiag > S1; Kurzschluß nach Masse liegt vor, wenn Vdiag < S2.

## Patentansprüche

1. Diagnoseeinrichtung zur Erkennung von Fehlschlüssen oder Leitungsunterbrechungen eines aus einer um einen magnetischen Kern gewickelten Spule bestehenden induktiven Sensors (1), dessen Ausgangssignal zur Weiterverarbeitung in einer Steuer- oder Regeleinrichtung (4) in einer Auswerteelektronik (3) in ein digitales Sensorsignal (Vout) gewandelt wird,
mit einem zwischen die Anschlüsse (5,6) des induktiven Sensors (1) geschalteten Spannungsteiler (7), dem an seinem Abgriff (8) über einen Widerstand (R1) eine Referenzspannung (Vref) zugeführt ist,
mit einer Auswerteeinrichtung (14, 15), in welcher das am Abgriff (8) abgreifbare Diagnosesignal (Vdiag) aufbereitet und das aufbereitete Signal mit Schwellwerten (S1, S2, S3, S3') verglichen wird, bei deren Über- oder Unterschreiten ein Fehlschluß oder eine Leitungsunterbrechung erkannt wird.

2. Diagnoseeinrichtung nach Anspruch 1, **dadurch gekennzeichnet, daß** der Spannungsteiler (7) symmetrisch ist (R2, R3).

3. Diagnoseeinrichtung nach Anspruch 1 oder 2, **dadurch gekennzeichnet**,
daß die Auswerteeinrichtung (14) einen Analog-Digitalwandler (18) aufweist, in welchem die Diagnosespannung (Vdiag) in laufend aufeinanderfolgenden Meßperioden Tm in konstanten oder in zeitlich ungleichen Abständen, die größer oder kleiner als die Periodendauer des Sensorsignals sind, abgetastet wird, wobei der größte Abtastwert (Vmax), der kleinste Abtastwert (Vmin) und deren Differenz (Vss) in jeder Meßperiode (Tm) ermittelt werden, und
eine Komparatoreinheit (19) aufweist, in welcher diese Werte (Vmax, Vmin, Vss) mit vorgegebenen Schwellwerten (S1, S2, S3) verglichen werden, wobei
im Stillstand der Brennkraftmaschine, wenn Vmax = Vmin = Vdiag, ein Kurzschluß nach Batteriespannung detektiert wird, wenn Vdiag > S1, ein Kurzschluß nach Masse detektiert wird, wenn Vdiag < S2, und
im Betriebsfall einer Brennkraftmaschine ein Kurzschluß nach Batteriespannung bzw. nach Masse oder eine Leitungsunterbrechung in den Sensorzuleitungen detektiert wird, wenn Vss > S3.

4. Diagnoseeinrichtung nach Anspruch 1 oder 2, **dadurch gekennzeichnet**,
daß die Auswerteeinrichtung (15) einen Hochpaß (20) aufweist, in welchem der Gleichspannunganteil der Diagnosespannung (Vdiag) weggefiltert wird,
einen Gleichrichter (21) aufweist, in welchem das verbleibende Sensorsignal gleichgerichtet und in einem nachfolgenden Kondensator (22) zu einem Gleichspannungssignal (Vss') geglättet wird, und
eine Komparatoreinheit (23) aufweist, in welcher die Diagnosespannung (Vdiag) mit dem ersten und zweiten Schwellwert (S1, S2) und das Gleichspannungssignal (Vss') mit einem dritten Schwellwert (S3') verglichen werden, wobei
im Stillstand der Brennkraftmaschine, wenn Vmax = Vmin = Vdiag, ein Kurzschluß nach Batteriespannung detektiert wird, wenn Vdiag > S1, ein Kurzschluß nach Masse detektiert wird, wenn Vdiag < S2, und
im Betriebsfall einer Brennkraftmaschine ein Kurzschluß nach Batteriespannung bzw. nach Masse oder ein Leitungsbruch in den Sensorzuleitungen detektiert wird, wenn Vss' > 53'.

5. Diagnoseeinrichtung nach Anspruch 3 oder 4, **dadurch gekennzeichnet, daß** die Komparatoreinheit (19, 23) mit einer Anzeigeeinheit (16) verbunden ist, in welcher in der Komparatoreinheit (19, 23) detektierte Fehlschlüsse oder Leitungsunterbrechungen angezeigt werden.

## Claims

1. Diagnostic device for detecting short circuits or line interruptions in an inductive sensor (1) which is composed of a coil wound around a magnetic core, the output signal of which sensor is converted into a digital sensor signal (Vout) for further processing in a control device (4) in an evaluation electronic system (3),
having a voltage divider (7) which is connected between the terminals (5, 6) of the inductive sensor (1) and to which a reference voltage (Vref) is fed at its tap (8) via a resistor (R1),
having an evaluation device (14, 15) in which the diagnostic signal (Vdiag) which can be tapped at the tap (8) is conditioned, and the conditioned signal is compared with threshold values (S1, S2, S3, S3'), a short circuit or a line interruption being detected when said threshold values (S1, S2, S3, S3') are exceeded or undershot.

2. Diagnostic device according to Claim 1, **characterized in that** the voltage divider (7) is symmetrical (R2, R3).

3. Diagnostic device according to Claim 1 or 2, **characterized in that** the evaluation device (14) has an analog/digital converter (18) in which the diagnostic voltage (Vdiag) is sampled in continuously successive measurement periods Tm in constant or in chronologically unequal intervals which are longer or shorter than the period length of the sensor signal, the largest sampled value (Vmax), the smallest sampled value (Vmin) and their difference (Vss) being determined in each measurement period (Tm), and
having a comparator unit (19) in which these values (Vmax, Vmin, Vss) are compared with predefined threshold values (S1, S2, S3), in which comparison when the internal combustion engine is stationary, if Vmax = Vmin = Vdiag a short circuit to the battery voltage is detected if Vdiag > S1 and a short circuit to earth is detected if Vdiag < S2 and, when an internal combustion engine is operating, a short circuit to the battery voltage or to earth or a line interruption in the sensor feeder lines is detected if Vss > S3.

4. Diagnostic device according to Claim 1 or 2, **characterized in that** the evaluation device (15) has a high-pass filter (20) in which the d.c. voltage component of the diagnostic voltage (Vdiag) is filtered out, has a rectifier (21) in which the remaining sensor signal is rectified and is smoothed in a following capacitor (22) to form a d.c. voltage signal (Vss'), and has a comparator unit (23) in which the diagnostic voltage (Vdiag) is compared with the first and second threshold values (S1, S2), and the d.c. voltage signal (Vss') is compared with a third threshold value (S3'), in which comparison, when the internal combustion engine is stationary, if Vmax = Vmin = Vdiag a short circuit to the battery voltage is detected if Vdiag > S1 and a short circuit to earth is detected if Vdiag < S2 and, when an internal combustion engine is operating, a short circuit to the battery voltage or to earth or a line interruption in the sensor feeder lines is detected if Vss' > S3'.

5. Diagnostic device according to Claim 3 or 4, **characterized in that** the comparator unit (19, 23) is connected to a display unit (16) in which short circuits or line interruptions which are detected in the comparator unit (19, 23) are displayed.

## Revendications

1. Dispositif de diagnostic destiné à reconnaître des contacts erronés ou des interruptions de ligne d'un capteur inductif (1) composé d'une self bobinée autour d'un noyau magnétisé, dont le signal de sortie est transformé, dans un système électronique d'analyse (3), en un signal numérique de capteur (Vout) en vue de son post-traitement dans un dispositif de commande ou de régulation (4),
avec un diviseur de tension (7), connecté entre les bornes (5, 6) du capteur inductif (1), auquel, en son point milieu (8), une tension de référence (Vref) est transmise à travers une résistance (R1),
avec un dispositif d'évaluation (14, 15), dans lequel le signal de diagnostic (Vdiag), qui peut être prélevé au point milieu (8), est préparé et dans lequel le signal préparé est comparé à des valeurs seuil (S1, S2, S3, S3'), un contact erroné ou une interruption de ligne étant reconnus lorsque ces valeurs sont dépassées vers le haut ou vers le bas.

2. Dispositif de diagnostic selon la revendication 1 **caractérisé par** le fait que le diviseur de tension (7) est symétrique (R2, R3).

3. Dispositif de diagnostic selon la revendication 1 ou 2 **caractérisé par** le fait
que le dispositif d'évaluation (14) comporte un convertisseur analogique-numérique (18), dans lequel la tension de diagnostic (Vdiag) est interrogée en permanence au cours de périodes de mesure Tm, qui se succèdent, à des intervalles de temps constants ou inégaux, qui sont plus longs ou plus courts que la longueur de la période du signal du capteur, la valeur d'interrogation la plus importante (Vmax), la valeur d'interrogation la plus faible (Vmin) et leur différence (Vss) étant déterminées au cours de chaque période de mesure (Tm), et
qu'elle comporte une unité de comparaison (19), dans laquelle ces valeurs (Vmax, Vmin, Vss) sont comparées à des valeurs seuil prédéterminées (S1, S2, S3),
un court-circuit vers la tension de batterie étant détecté lorsque Vdiag > S1 et un court-circuit vers la masse étant détecté lorsque Vdiag < S2,
à l'arrêt du moteur à combustion inteme, lorsque Vmax = Vmin = Vdiag, et
un court-circuit vers la tension de batterie ou vers la masse ou une interruption de ligne sur les conducteurs conduisant au capteur étant détectés lorsque Vss > S3, au cours du fonctionnement d'un moteur à combustion interne.

4. Dispositif de diagnostic selon la revendication 1 ou 2 **caractérisé par** le fait que le dispositif d'évaluation (15) comporte un passe-haut (20) dans lequel la composante tension continue de la tension de diagnostic (Vdiag) est supprimée, un redresseur (21), dans lequel le signal de capteur, qui en résulte, est redressé, puis lissé dans un condensateur en aval (22) pour former un signal de tension continue (Vss') et
une unité de comparaison (23), dans laquelle la tension de diagnostic (Vdiag) est comparée à la première et à la deuxième valeur seuil (S1, S2) et le signal à tension continue (Vss') à une troisième valeur seuil (S3'),
un court-circuit vers la tension de batterie étant détecté lorsque Vdiag > S1 et un court-circuit vers la masse étant détecté lorsque Vdiag < S2,
à l'arrêt du moteur à combustion interne, lorsque Vmax = Vmin = Vdiag, et
un court-circuit vers la tension de batterie ou vers la masse ou une interruption de ligne sur les conducteurs conduisant au capteur étant détectés lorsque Vss' > S3', au cours du fonctionnement d'un moteur à combustion interne.

5. Dispositif de diagnostic selon la revendication 3 ou 4 **caractérisé par** le fait que l'unité de comparaison (19, 23) est reliée à une unité d'affichage (16), dans laquelle sont affichés les contacts erronés ou les interruptions de lignes détectés dans l'unité de comparaison (19, 23).
